**Europäisches Patentamt**

**European Patent Office**

**Office européen des brevets**

(19)

(11) Veröffentlichungsnummer: **0 249 725 B1**

(12) # EUROPÄISCHE PATENTSCHRIFT

(45) Veröffentlichungstag der Patentschrift: 27.03.91

(51) Int. Cl.⁵: **H03K 17/08, H03K 17/73**

(21) Anmeldenummer: 87106345.9

(22) Anmeldetag: 02.05.87

(54) **Hochspannungshalbleiterschütz.**

(30) Priorität: 14.06.86 DE 3620074

(43) Veröffentlichungstag der Anmeldung:
23.12.87 Patentblatt 87/52

(45) Bekanntmachung des Hinweises auf die
Patenterteilung:
27.03.91 Patentblatt 91/13

(84) Benannte Vertragsstaaten:
AT BE CH DE ES FR IT LI NL

(56) Entgegenhaltungen:
DE-A- 3 419 652
FR-A- 1 557 229

ELEKTROTECHNISCHE ZEITSCHRIFT. E.T.Z.,
Band 104, Nr. 24, Dezember 1983, Seiten
1246-1251, Berlin; W. BÖSTERLING et al.:
"Thyristorarten ASCR, RLT und GTO - Technik und Grenzen ihrer Anwendung"

PATENT ABSTRACTS OF JAPAN & JP-
A-52-120 669 (MITSUBISHI DENKI K.K.)
11.10.1977

BROWN BOVERI REVIEW, Band 71, Nr. 5, Mai
1984, Seiten 216-221, Baden, CH; J. VITINS et
al.: "Use of power semiconductors made
easier by forward integration"

(73) Patentinhaber: **Licentia Patent-
Verwaltungs-GmbH
Theodor-Stern-Kai 1
W-6000 Frankfurt/Main 70(DE)**

(72) Erfinder: **Langer, Günther
Mohrunger Allee 6a
W-1000 Berlin 19(DE)**
Erfinder: **Wolf, Thomas
Räuschstrasse 28
W-1000 Berlin 27(DE)**
Erfinder: **Rjosk, Heinz
Bergmannstrasse 57
W-1000 Berlin 61(DE)**
Erfinder: **Mues, Michael
Wollankstrasse 72
W-1000 Berlin 65(DE)**

(74) Vertreter: **Lertes, Kurt, Dr. et al
Licentia Patent-Verwaltungs-GmbH Theodor-
Stern-Kai 1
W-6000 Frankfurt/M 70(DE)**

**Beschreibung**

Die Erfindung bezieht sich auf ein Hochspannungshalbleiterschütz, wie es im Oberbegriff des Anspruches 1 näher definiert ist. Dabei soll ein Leistungsteil aus der Reihenschaltung von zwei GTO-Thyristoren mit RCD-Beschaltung Verwendung finden, wie es generell und nicht speziell auf Hochspannungshalbleiterschütze bezogen z.B. der Elektrotechnischen Zeitschrift (ETZ), Band 104, Nr. 24, Dezember 1983, S. 1246 für GTO-Thyristoren oder den Patent Abstracts of Japan zu JP-A-52-120669, veröffentlicht 11.10.1977, für Normalthyristoren entnehmbar ist. In der ETZ wird auch der Überspannungsschutz und in den Abstracts die Spannungsaufteilung behandelt, beides bekannter Stand der Technik.

Halbleiterschütze weisen Eigenschaften auf, die von den bisher verwendeten elektromechanischen Schaltgeräten nicht mehr erfüllt werden können. Man ist dort an die Grenzen der technischen Möglichkeiten herangekommen. So ist die Schalthäufigkeit und Lebensdauer zwar schon hoch, jedoch begrenzt. Nachteilig ist auch der Verschleiß der Schaltstücke und Lager, was die Geräte sehr wartungsintensiv macht. Für Anwendungsfälle mit sehr hoher Schalthäufigkeit - insbesondere Taktbetrieb - ergeben sich für elektromechanische Hochspannungsschütze aus dieser Sicht Grenzen und Probleme.

Aufgabe der Erfindung ist es, eine solche Schaltung - wie sie eingangs als bekannt vorausgesetzt wurde - für die Schaffung und mechanische Realisierung eines Hochspannungsschützes auf Halbleiterbasis nutzbar zu machen, das problemlos ein verschleiß-und wartungsfreies Schalten elektrischer Gleichstromlasten mit sehr hoher Schalthäufigkeit gestattet. Dabei ist an Spannungen um 1000 V mit Strömen zwischen 0,5 bis 15 A und darüber gedacht. Es soll einfach und kompakt im Aufbau und in seiner Montagehandhabung sein und mechanische Schütze austauschbar ersetzen können

Gelöst wird diese Aufgabe gemäß den kennzeichnenden Merkmalen des Anspruches 1. Eine vorteilhafte Ausgestaltung ist dem Unteranspruch entnehmbar.

Es ist zwar schon für HF-Umrichtereinheiten für Induktionshiezung bekannt. Stapel aus abwechselnd geschichteten Normalthyristoren und Wasserkühlern zu bilden (BROWN BOVERIE REVIEW, Band 71, Nr. 5, Mai 1984, S. 219/220, Baden, CH). Das hat jedoch nichts mit der aufgezeigten Erfindung bei Halbleiterschützen zu tun und gibt auch keine Anregung zur Lösung der aufgezeigten Problemstellungen.

Anhand eines Ausführungsbeispieles wird die Erfindung im nachstehenden näher erläutert. Es zeigen:

Fig. 1 eine Schaltungsanordung
Fig. 2 den mechanischen Aufbau eines solchen Schützes
Fig. 3 einen Seitenschnitt.

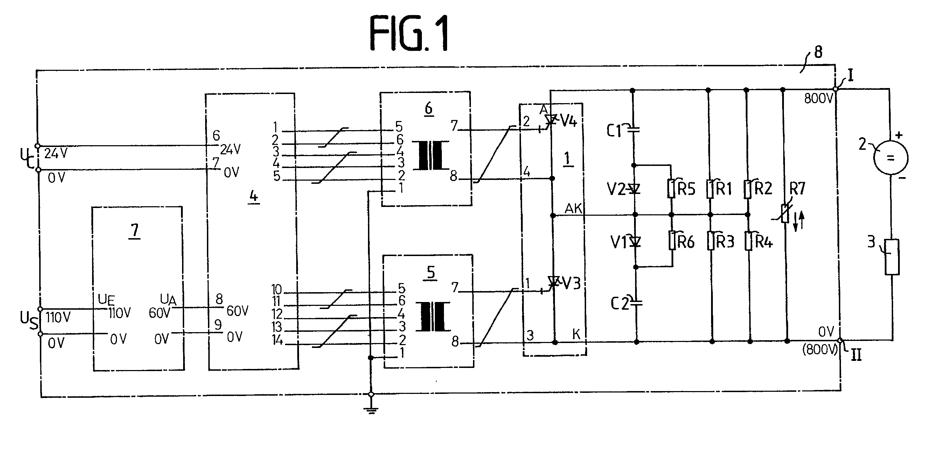

In Fig. 1 sind mit V3 und V4 zwei in Reihe geschaltete GTO-Thyristoren dargestellt, die in einem sogenannten Powerblock 1 zusammengefaßt sind und über die eine von einer Gleich-Hochspannungsquelle 2 gespeiste Last 3 geschaltet wird. Die Anodenseite ist mit A, die Kathodenseite mit K und der kathoden/anodenseitige Zusammenschluß mit AK bezeichnet. Für die gleichmäßige dynamische Sperrspannungsaufteilung der GTO-Thyristoren V3, V4 ist eine RCD-Beschaltung mit den Elementen C1, R5, V2 bzw. C2, R6, V1 vorgesehen. Die statische Spannungsaufteilung wird durch zwei mal zwei parallel geschaltete Widerstände R1 bis R4 besorgt. Je zwei parallele Widerstände liegen anodenseitig (A) am GTO-Thyristor V4 und zwei weitere parallele Widerstände liegen kathodenseitig (B) am GTO-Thristor V3 und sie sind im Spannungsteilerpunkt mit dem Zusammenschluß AK der GTO-Thyristoren verbunden. Zum Schutz vor netzseitigen Überspannungen dient ein Metalloxyde-Varistor R7. Die Zünd- und Löschimpulse für die Abschaltthyristoren V3, V4 werden auf einer Platine oder Leiterplatte 4 gebildet und verstärkt. Die Impulse werden ventilgeordnet über spezielle Leiterplatten 5 und 6, auf denen Zündübertrager untergebracht sind, potentialgetrennt an die GTO-Thyristoren geführt. Die noch abgebildete Leiterplatte 7 dient der Anpassung auf die von den Leiterplatten 5 und 6 benötigte Spannung von z.B. DC 60 V. Im angenommenen Fall steht hier fahrzeugseitig eine Versorgungsspannung $U_S$ von DC 110 V zur Verfügung. Diese Leiterplatte 7 kann natürlich entfallen, wenn die Leiterplatten 5 und 6 über die Übertrager selbst an die nötigen Versorgungsspannungen angepaßt werden. Der Leistungsteil mit dem Powerblock 1 und der Steuerteil mit den Elementen 4 bis 7 sind auf einem verrippten Kühlkörper 8 untergebracht, der gleichzeitig als Montageplatte dient.

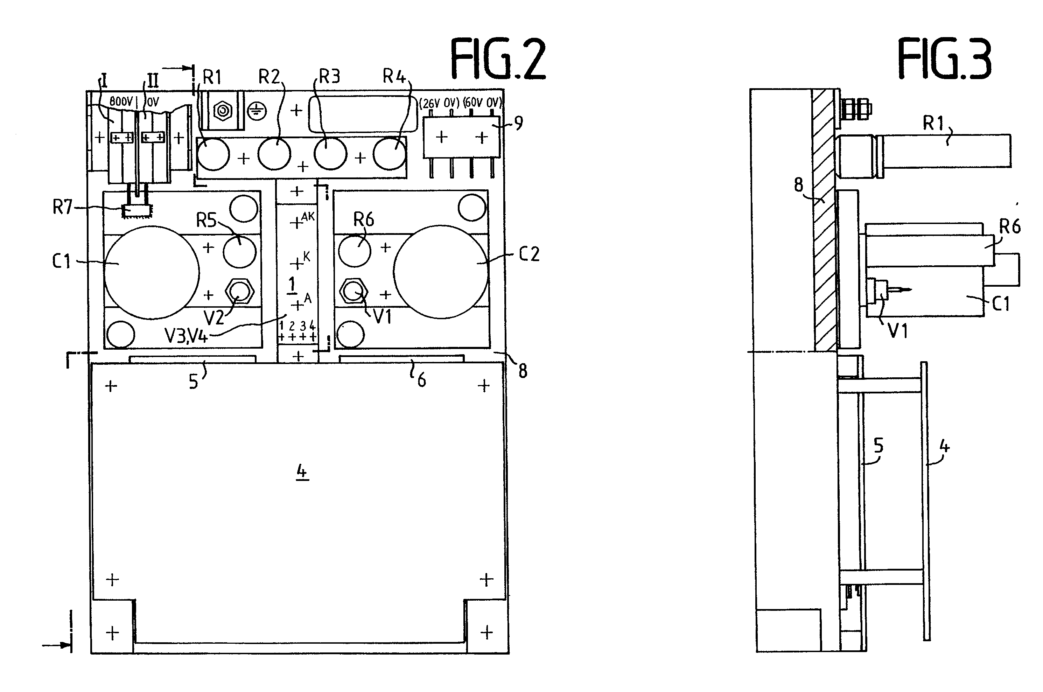

Die mechanische Anordnung geht aus den Figuren 2 und 3 hervor. Etwa in der Mitte vom Kühlkörper 8 sind die GTO-Thyristoren V3 und V4 des Powerblocks 1 sichtbar. Rechts und links daneben (in dieser Ansicht) sind die Kondensatoren C1 und C2 der RCD-Beschaltung angeordnet. Im oberen Bereich sind ferner die Anschlußklemmen I, II des Hauptstrompfades, sowie die Flachstecker 9 der Versorgungsspannung $U_S$ und der Steuerspannung $U_C$ erkennbar.

Auf dem - hier in dieser Fig.2 - unteren Teil des Kühlkörpers 8 sind in isolierter Doppeletagenanordnung einerseits die zwei Leiterplatten 5 und 6 mit den Zündübertragern für die GTO-Thyristoransteuerung (nur andeutungsweise sichtbar und weitgehend verdeckt) und darüber die weitgehend alles verdeckende Leiterplatte 4 für die Zünd- und Löschimpulsbildung sowie Verstärkung montiert. Eine Leiterplatte 7 zur Anpassung der Versorgungsspannung ist hier nicht vorgesehen.

Fig. 3 zeigt noch ergänzend die Lage der Teile in einem teilweisen Seitenschnitt.

Zu beachten ist, daß das Halbleiterschütz im Aus-Zustand keine Kontaktunterbrechung im Hauptstromkreis hat. Daher muß beim Anliegen der Netzspannung der Hauptstromkreis auf der Lastseite - auch im Aus-Zustand des Schützes - immer als spannungsführend angesehen werden.

## Ansprüche

1. Hochspannungshalbleiterschütz, bei dem der Leistungsteil aus der Reihenschaltung von zwei GTO-Thyristoren (V3,V4) RCD-Beschaltung besteht, denen Mittel zur statischen Spannungsaufteilungund (R1/R3,R2/R4) zum Überspannungsschutz (R7) zugeordnet sein können,
**dadurch gekennzeichnet ,**
daß der Leistungsteil zusammen mit einem Steuerteil nebeneinander unter Potentialtrennung auf einem gemeinsamen Kühlkörper (8) untergebracht ist, der gleichzeitig als Montageplatte dient und daß dabei der Steuerteil aus einer Platine (4) für die Zünd- und Löschimpulsbildung und zwei weiteren Platinen (5, 6) für die Zünd- und Löschimpulsübertragung gebildet wird, von denen die Platinen (5, 6) für die Zünd- und Löschimpulsübertragung nebeneinander liegend dicht am Kühlkörper angeordnet sind und die Platine (4) für die Zünd- und Löschimpulsbildung etagenartig darüber liegt.

2. Hochspannungshalbleiterschütz nach Anspruch 1,
**dadurch gekennzeichnet,**
daß auf dem Kühlkörper (8) noch ein den Ausgangshauptanschlüssen (I, II) des Leistungsteils parallelgeschalteter Überspannungsschutz (R7), vorzugsweise ein Metalloxyd-Varistor, untergebracht ist.

## Claims

1. High-voltage semiconductor relay, in which the power part consists of the series connection of two GTO thyristors (V3, V4) with RCD wiring which can be associated with means for static voltage distribution (R1/R3, R2/R4) and for excess voltage protection (R7), characterised thereby, that the power part is housed together with a control part one beside the other with potential separation on a common cooling body (8), which at the same time serves as support plate and that the control part is in that case formed of a mounting plate (4) for the ignition and quenching pulse formation and two further support plates (5, 6) for the ignition and quenching pulse transmission, of which the support plates (5, 6) for the ignition and quenching pulse transmission are arranged to lie closely to the cooling body and the mounting plate (4) for the ignition and quenching pulse formation lies in tiered manner thereover.

2. High-voltage semiconductor relay according to claim 1, characterised thereby, that an excess voltage protection, preferably a metal oxide varistor, which is connected in parallel with the main output connections (I, II) of the power part, is still housed on the cooling body (8).

## Revendications

1. Contacteur à semiconducteurs pour haute tension dans le cas duquel la partie puissance est constituée d'un circuit de série de deux thyristors interruptibles (GTO) (V3, V4) et d'un circuit RCD (résistance-condensateur-diode) auxquels on peut ajouter des moyens pour la division statique de la tension (R1/R3, R3/R4) et pour la protection contre les surtensions (R7),
caractérisé
par le fait que la partie puissance est logée, avec une partie commande, l'une à côté de l'autre, avec séparation des potentiels, sur un radiateur commun (8) qui sert simultanément de plaque de montage, et par le fait que la partie commande y est formée d'une platine (4) pour la formation des impulsions d'amorçage et de désamorçage et de deux autres platines (5, 6) pour la transmission des impulsions d'amorçage et de désamorçage, dont les platines (5, 6) pour la transmission des impulsions d'amorçage et de désamorçage sont disposées, l'une à côté de l'autre, étroitement sur le radiateur et dont la platine (4) pour la formation des impulsions d'amorçage et de désamorçage se trouve par-dessus, en étage.

2. Contacteur à semiconducteurs pour haute tension selon la revendication 1,
caractérisé
par le fait que sur le radiateur (8) est encore logé un disjoncteur de protection contre les surtensions (R7), de préférence une varistance à oxyde métallique, monté en parallèle aux bornes principales de sortie (I, II) de la partie puissance.

# FIG.1

EP 0 249 725 B1

FIG.3

FIG.2